Europäisches Patentamt

European Patent Office

Office européen des brevets

(11) Publication number: **0 066 020**
**B1**

(19)

## EUROPEAN PATENT SPECIFICATION

(12)

(45) Date of publication of patent specification: **23.10.85**

(51) Int. Cl.⁴: **H 01 L 27/14,** H 04 N 5/33

(21) Application number: **81302462.7**

(22) Date of filing: **03.06.81**

(54) **Infrared energy detector system utilizing a charge transfer device sensor.**

(43) Date of publication of application:
**08.12.82 Bulletin 82/49**

(73) Proprietor: **TEXAS INSTRUMENTS
INCORPORATED
13500 North Central Expressway
Dallas Texas 75265 (US)**

(45) Publication of the grant of the patent:
**23.10.85 Bulletin 85/43**

(72) Inventor: **Chapman, Richard A.
7240 Briarcove Drive Dallas
Dallas County Texas (US)**

(84) Designated Contracting States:
**DE FR GB IT**

(74) Representative: **Abbott, David John et al
Abel & Imray Northumberland House
303-306 High Holborn
London, WC1V 7LH (GB)**

(56) References cited:
**DE-A-2 842 346
GB-A-1 179 823
GB-A-1 569 574
GB-A-1 589 462
US-A-3 912 927
US-A-4 231 149
US-A-4 257 057**

(56) References cited:
**IEEE Transactions on Electron Devices, vol.
ED-27, no. 1, January 1980, New York R.E.
CHAPMAN "Monolithic HgCdTe Charge
Transfer Device Infrared Imaging Arrays" pages
134-145**

**IEEE Transactions on Electron Devices, vol.
ED-27, no. 1, January 1980, New York P. FELIX
"CCD Readout of Infrared Hybrid Focal-Plan
Arrays" pages 175-188**

**IEEE Transactions on Electron Devices, vol.
ED-27, no. 1, January 1980, New York R.D.
THOM "A Fully Monolithic InSb Infrared CCD
Array" pages 160-170**

Courier Press, Leamington Spa, England.

# Description

This invention relates the infrared detector systems and more particular to an infrared detector system utilizing charge transfer device sensors.

Infrared energy imaging systems are two types: staring and non-staring. Non-staring systems include: an optical assembly for focusing infrared energy emanating from a scene within the field-of-view; a scanning assembly for scanning the focused energy, and an infrared detector for converting the scanned energy into electrical signals representative of the scene for a signal processor. The signal processor includes a preamplifier for amplifying the electrical signals to a working level for processing into video signals. The signal from the prior art infrared detector which does not use time delay and integration is directly proportional to the time required for the smallest resolvable image pixel to pass across the detector (integration time); the radiation-background-limited noise and background-limited signal-to-noise ratio are directly proportional to the square-root of the integration time. The integration time is set by the image scan velocity and the size of the detector; thus, the integration time cannot be arbitrarily increased for the prior art detector.

The infrared detector fabricated on an infrared sensitive material such as HgCdTe has included a parallel shift register whcih is read out to a single floating gate or diode output. The parallel register has two, three or four phases per stage. The circuit used at the floating gate can include (1) an on chip output and reset field effect transistors (FETs) or (2) a silicon chip with output and reset field effect transistors. Each stage in the shift register constitutes one infrared detector; therefore, a shift register with "n" stages has "n" infrared detectors read out from one floating gate or diode output.

The infrared detector is used in conjunction with the mechanical scanner which moves an infrared image parallel to the direction of charge transfer in the parallel register. The velocity of motion of the infrared imager is made equal to the average velocity of motion of the charges in the register. Thus, as an infrared picture element (pixel) is scanned in synchronization with the phase movement, each bit of data exiting the parallel register has seen the same infrared pixel during its movement through the parallel register.

A fuller description of such a detector may be found in the IEEE Transactions on Electronic Devices, Vol. ED-27, No. 1, January 1980, pp. 134—145, an article entitled "MONOLITHIC HgCdTE CHARGE TRANSFER DEVICE INFRARED IMAGING ARRAYS" by Richard A. Chapman et al in which is described an infrared detector array where the scene is scanned in synchronism with the clocking of the potential wells of the array.

Accordingly, the problem in the prior art has been that the charge packets in the parallel shift register potential wells increase in size from the first to the last stages and overflow after saturation. To prevent the overflow, the integration time for signal photons has to be curtailed. However, as the signal output is directly proportional to the integration time, this limitation set by overfilling is very deleterious. In the prior art devices, the maximum capacity has been set by electric field breakdown in the empty well in the infrared sensitive semiconductor such as mercury telluride.

In the present invention, larger capacity is obtained by using successively larger voltages and well depths down the parallel shift register: the infrared background provides an increasing background fat zero charge which can be set to keep the available charge capacity and electric field constant along the length of the shift register.

According to the present invention there is provided an infrared energy detector system comprising: a scanning assembly for scanning at a preselected rate a scene emitting infrared energy; an infrared detector matrix of charge coupled devices in the scanning path of the scanning assembly for converting the impinging infrared energy into electrical charge packets representative of received infrared energy, said infrared detector matrix comprising a plurality of charge coupled device elements arranged in rows and columns, elements of the columns of charge coupled devices being selectively connected together to form a plurality of integration stages, and means for applying selected phase clock pulses to said integration stages to synchronise the movement of the charge packets through said matrix with the scanning of the image of the scene by the scanning assembly; and signal processing means for processing the integrated signals into video signals representative of the infrared energy emanating from the scene; CHARACTERIZED in that the means for applying phase clock pulses includes means for providing at least two phase clock pulses having the same phase but different amplitude to produce electrical charge packets in the first stage which are integrated with the charge packets of each succeeding stage of the plurality of integration stages to provide time delay with integration of charge packets within said matrix thereby producing integrated signals representative of the scene.

In a charge coupled device (CCD) shift register, a fat zero charge must be placed in the well to cover up surface states and improve charge transfer efficiency. A fat zero requirement of 30% is a typical requirement for good charge transfer efficiency. A fat zero charge is usually put in at the far end of a shift register and the fat zero charge diminishes the charge capacity available to store infrared background and signal generated charge. The continuous clocks used in operating the parallel register stages in an infrared background result in the collection of infrared generated or dark current generated charge. This charge generated by infrared background or dark current constitutes an additional fat zero charge which increases from the first to the last stage of the CCD. The presence of this larger fat zero charge in the last stage and very little fat zero charge in the initial stage, results in good charge transfer efficiency (CTE) in the last stage and a substantially degraded (CTE) in the first stage where charge transfer efficiency has its largest effect on performance.

An advantage of this invention is that it can provide an infrared energy detection and imaging system having improved sensitivity and signal-to-noise ratio.

The invention can improve the infrared energy collection efficiency through an increase in integration time.

The invention can increase the storage capacity of the infrared energy storage sites.

The invention can improve the charge transfer efficiency for transferring infrared energy charge packets.

In one embodiment the invention comprises a forward looking infrared (FLIR) system including a lens assembly, scanning assembly, detector assembly and video electronic circuitry. The detector assembly comprises a ramped charge transfer device (CTD) matrix. The matrix includes a plurality of charge transfer device elements arranged in rows and columns. Each pair of rows of elements constitutes a stage and each element of each stage is a CTD having a preselected number of phase electrodes which are used selectively for the collection of charge packets representative of impinging infrared energy and to transfer the charge packets to successive stages. Increasing (ramping) voltages are applied to selected elements of each stage to successively increase the charge collecting capacity of the matrix. The application of these ramping voltages are synchronized with the scanning rate. Thus each stage of elements sees the same image, and after the first stage, the next stage collects the charge packet of the preceeding stage and adds to it an additional charge packet representative of the same scene portion. In this manner, the voltage indicative of the scene is substantially increased to a working voltage and the integration time is substantially increased.

A detailed description of a preferred embodiment of this invention follows with reference being made to drawings wherein like parts have been given like reference numerals for clarity and understanding of the elements and features of the invention.

FIGURE 1 is a block diagram of a forward looking infrared system;

FIGURES 2a and 2b are views showing the charge transfer device matrix and related circuitry;

FIGURE 3 is a partial cross-sectional view of the parallel shift register taken along line A—A of Figure 2a;

FIGURE 4 is a partial cross-sectional view of the serial shift register taken along line B—B of Figure 2a;

FIGURE 5 is a view showing the clock pulses or voltages corresponding to the division of the phase 2 and phase 4 clocks for three groups of stages a, b and c;

FIGURE 6 is a view showing the build up of signal and background charge in the ramped wells as a bright image pixel is moved in synchronization with the potential wells;

FIGURE 7 is a view showing the build up of signal and background charge in a prior art art·system; and

FIGURE 8 is a plan view of a second embodiment of the invention.

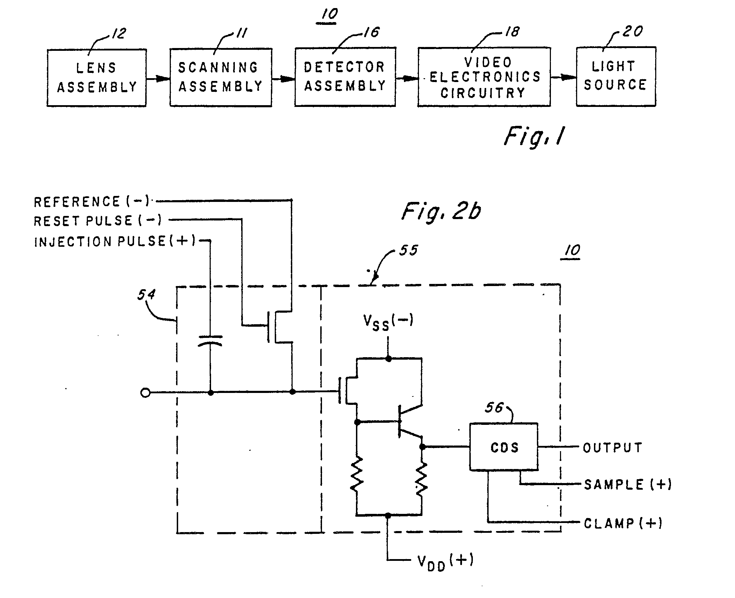

Referring now to Figure 1, the forward looking infrared system 10 comprises a lens assembly 12, scanning assembly 14, detector assembly 16, video electronics circuitry 18, and a display or light source 20. The lens assembly 12 is comprised of three lens elements, not shown, which for operation in the infrared region, may consist of three germanium elements. These elements collect infrared energy emanating from a scene and focus this energy onto a rotating mirror, not shown, of the scanning assembly 14. The rotating or nutating mirror may be, for example, a two sided flat mirror. The first side, or front surface, of the mirror is used to receive the infrared energy, and the second side, or rear surface, of the mirror is used to scan the modulated visible light from the light source 20. The scanning mirror is positioned with its "Y" axis normal to the optical axis and its "X" axis at a 45° angle thereto. The scanning mirror is rotated at a rate to provide a preselected frequency such as, for example, 30 or 60 scans/sec. by a small synchronous motor or in some instances by a solenoid. The solenoid causes the mirror to move against a return spring for oscillation. The scanning mirror reflects the infrared energy to a folding mirror, not shown, for reflection onto the detector array of detector assembly 16, hereinafter described in detail. The detector array converts the infrared energy to electrical signals for processing in the video electronics circuitry 18. The video electronics provides the signal processing auxiliary functions to modulate the output of the light source 20 or other display means. The light source or display 20 may be an array of light emitting diodes or a cathode ray tube (CRT). Those desiring details of suitable structures for the above elements are referred to U.S. Patent No. 3,912,927 issued October 14, 1975 to Richard G. Hoffman, II, for an "Opto-Mechanical Device for Phase Shift Compensation of Oscillating Mirror Scanners."

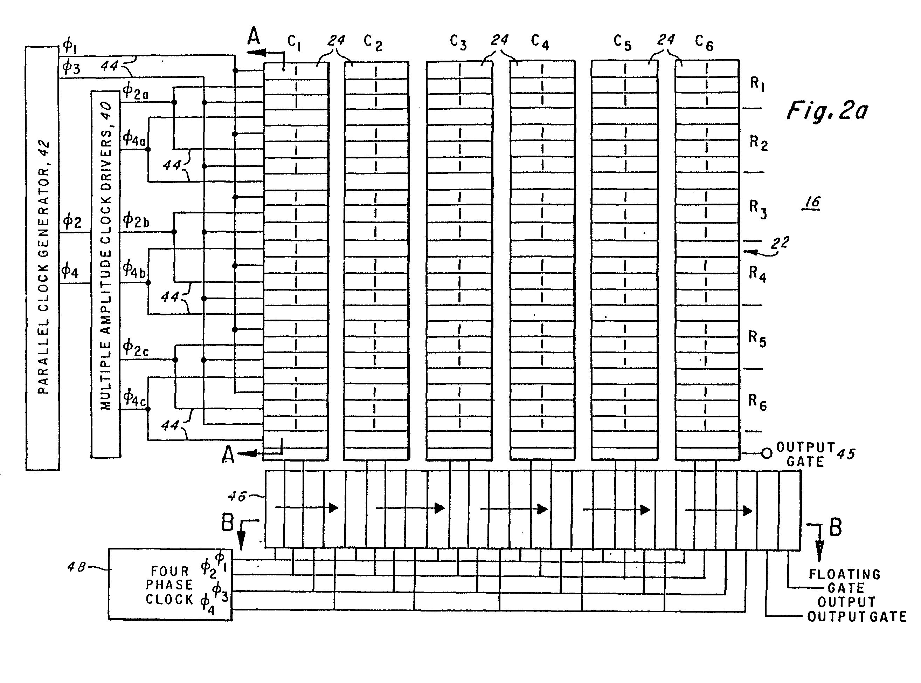

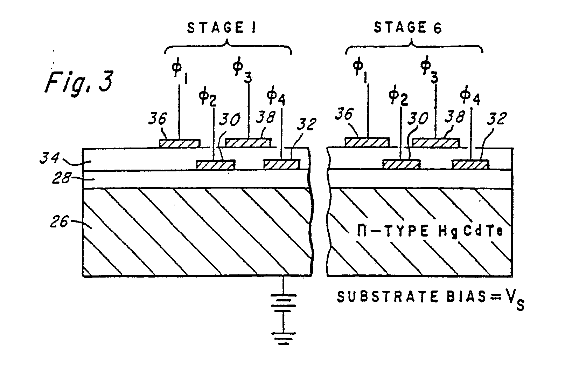

Referring now to Figures 2a and 2b, the detector array assembly 16 comprises a charge transfer device (CTD) infrared sensor matrix 22. The CTD matrix 22 is preferably a charge coupled device (CCD) matrix. The CCD matrix 22 is essentially a plurality of parallel CCD shift registers with their CCD elements 24 arranged in rows and columns. A six by six element array 22 is shown for disclosure purposes, although it will be appreciated that large arrays will be used in practice. Each element 24 (Fig. 2a) is formed on a semiconductor substrate 26 (Fig. 3); the substrate is, for example, an n-type mercury/cadmium/ telluride (HgCdTe) substrate. Other suitable materials are PbSnTe, InAsSb, and CaInSb. A layer 28 of insulating material such as, for example, ZnS is formed on the substrate 26, and the layer is metalized with an infrared transparent metal such as, for example, nickel 10—15 nm (100 to 150 Angstrom units) thick to form a plurality of first level electrodes 30 and 32. A second layer 34 of the insulating material is formed on the first layer 28 over the electrodes 30 and 32, and the second layer is metalized with another infrared transparent metal such as thin nickel, to form a plurality of second level electrodes 36 and 38. The electrodes 36 and 38 are formed in an overlapping relationship to electrodes 30 and 32. Those persons skilled in the art desiring detailed information for the construction of the CCD register elements are referred to US—A—4231149 (Serial No. 950,191 filed October 10, 1978) for a "Narrow Bandgap Semiconductor CCD Imaging Device and Method of Fabrication."

The electrodes 30, 32, 36 and 38 of each stage of the parallel shift register are connected by metalized bus lines 44. The metal bus lines are connected either directly to the four phase parallel clock generator 42 or indirectly to the clock generator through a clock driver 40 (variable amplitude generator) which provides several different amplitude (ramping) pulses for the phase-2 and phase-4 waveforms. The frequency of the parallel clock generator is set at a value to provide synchronization of the moving potential wells and the moving infrared image. The detector element 24 of each column are connected to the bus lines as follows: the phase 1 electrode of each element are connected together; the phase 2 electrodes are connected successively in pairs; the phase 3 electrodes are connected together; and the phase 4 electrodes are connected successively in pairs. The phase 1 and phase 3 electrodes, as transfer gates receive a preselected voltage $V_1$. The phase 2 and phase 4 electrodes of stages A, B and C receive a preselected voltage $V_{2a}$, $V_{2b}$, and $V_{2c}$, respectively. The voltages $V_{2a}$, $V_{2b}$, and $V_{2c}$ are of stepped values which are small for the first stages and largest for the last stages. For purposes of disclosure the phase 2 and 4 phase electrodes are grouped in pairs; other groupings such as one per clock amplitude or any number larger than two per clock amplitude could also be used based on a compromise between a need for a near continuous increase in amplitude (linear ramp) and a need to limit the maximum number of clock amplitudes and bond pads to the bus lines.

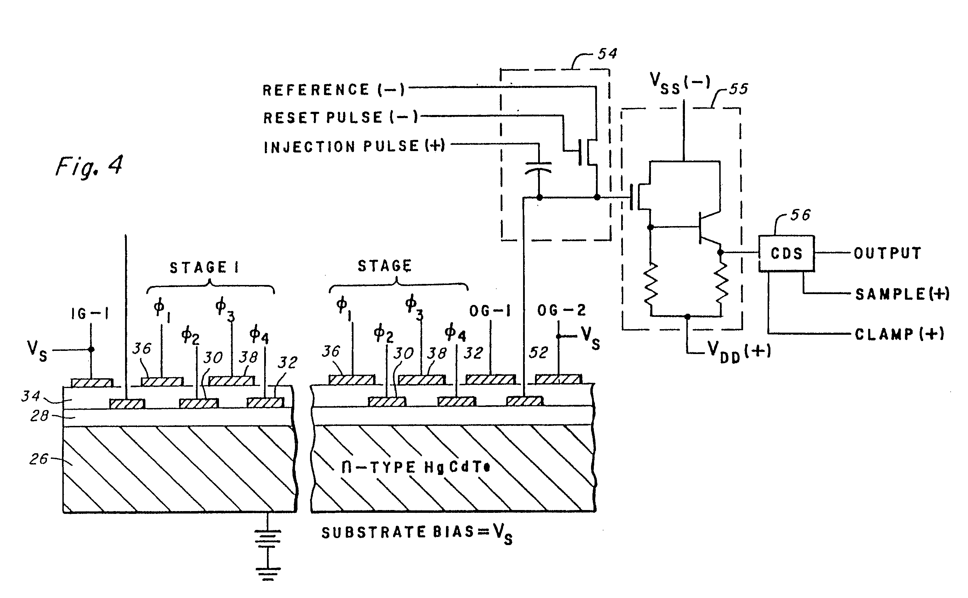

A serial shift register 46 is connected to the column outputs of the parallel shift register 22 by means of an output gate 45. The serial shift register 46 is also a four phase CCD shift register (Fig. 4) whose parts are identical to those of the parallel shift register, but each potential well is wider as shown in Figure 2a to provide sufficient charge capacity to hold the ramped charge packet output of the parallel shift register matrix by means of fixed value (not ramped) serial clocks. A serial clock generator 48 (Fig. 2a) controls the phase operation of the serial shift register.

The output of the serial shift register 46 is either a floating gate 52 of a diode (Fig. 4) fabricated on the infrared sensing semiconductor. The floating gate 52 (Fig. 4) is a metal, insulator, semiconductor (MIS) structure. That is, it has a semiconductor substrate supporting an insulating layer, and a metalized electrode on top of the insulating layer fabricated in the same manner as the phase electrodes. The floating gate has a capacity sufficient to hold each integrated charge packet. The sufficient capacity at maximum empty well voltage is obtained by increased area (i.e. width or width and length. The floating gate 52 or diode is connected to buffer circuit 55, reset FET 54, and clamp, sample, and hold circuit 56 of the video electronics circuitry 18. The clamp-sample-and-hold circuitry 18 will be fabricated in a silicon chip separate to the infrared sensing chip. In one embodiment, the buffer FET and reset FET will be fabricated in the infrared sensing semiconductor. In another embodiment, the buffer FET and reset FET will be fabricated on a silicon chip adjacent to the infrared sensing semiconductor chip.

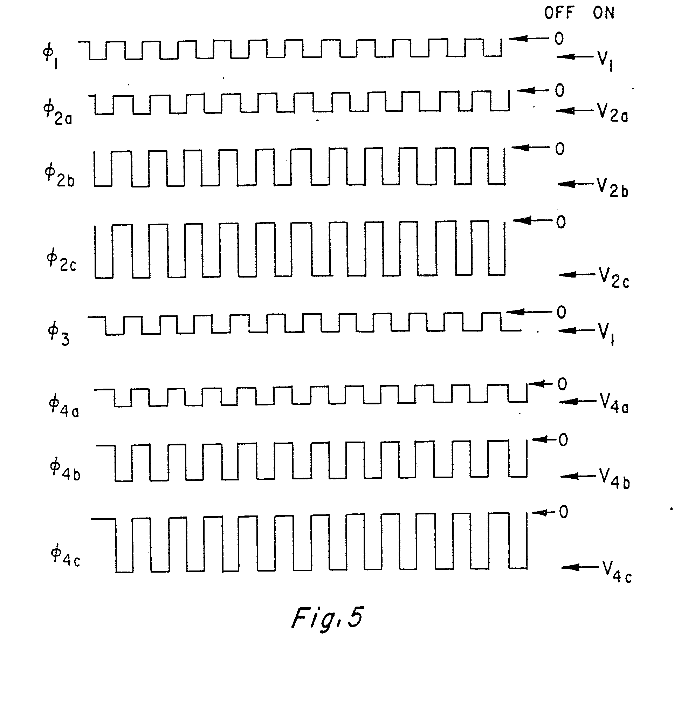

In ramped operation (Fig. 5), larger clock voltages $V_1$, $V_{2a}$, $V_{2b}$, and $V_{2c}$ are used for each stage of the parallel register matrix 22 (Fig. 2a). Ramping is most important for the longer wavelength (narrow bandgap) CCDs in which 4—12 parallel stages are adequate to obtain significant improvement in signal-to-noise ratio. As shown in Figure 5, a clock pulse of voltage $V_1$ is applied simultaneously to each phase 1 electrode of the CCD elements making up a column of the shift register matrix. Just before the phase 1 clock pulse goes off, clock pulses of voltages $V_{2a}$, $V_{2b}$ and $V_{2c}$ are applied, respectively, to the phase 2 elecrodes of the pairs of CCD elements forming stages A, B, and C. Then just before the clock pulses for the phase 2 electrodes go off, a clock pulse of voltage $V_1$ is applied simultaneously to each phase-3 electrode and concomitantly therewith the phase-1 clock pulse goes off. Finally, just before the phase-3 clock pulse goes off, clock pulses of voltages $V_{4a}$, $V_{4b}$, and $V_{4c}$ are applied, respectively, to the phase 4 electrodes and concomitantly therewith the phase-2 clock pulses go off.

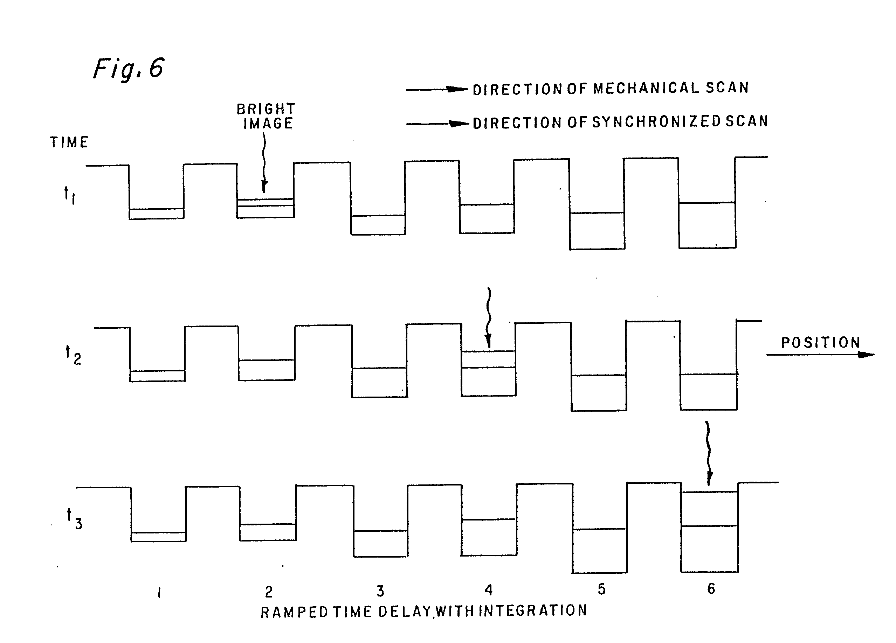

As previously mentioned, the average rate of clocking is synchronized with the scan rate of the system. Thus, as shown in Figure 6, at stage A and time $t_1$ a bright image is scanned and focused on the second phase-2 potential well; at time $t_2$ the charge packet representative of the bright image of stage A arrives at the fourth phase-2 potential well or second potential well of stage B simultaneously with the focusing of the same bright image detected in the second scan; and at time $t_3$ the integrated charge packets of stages A and B arrive at the sixth phase-2 potential well or second potential well of stage C simultaneously with the focusing of the same bright image detected in the first and second stages. The ramping voltages of Figure 5 provide adequate capacity for the total charge of the charge packets which include infrared background and signal generated charge. The integrated charge packet is then outputted to the serial shift register and clocked out to the floating gate. The size of each element of the serial shift register is sufficient to hold the integrated charge packet. Thus, the system provides for time delay with integration.

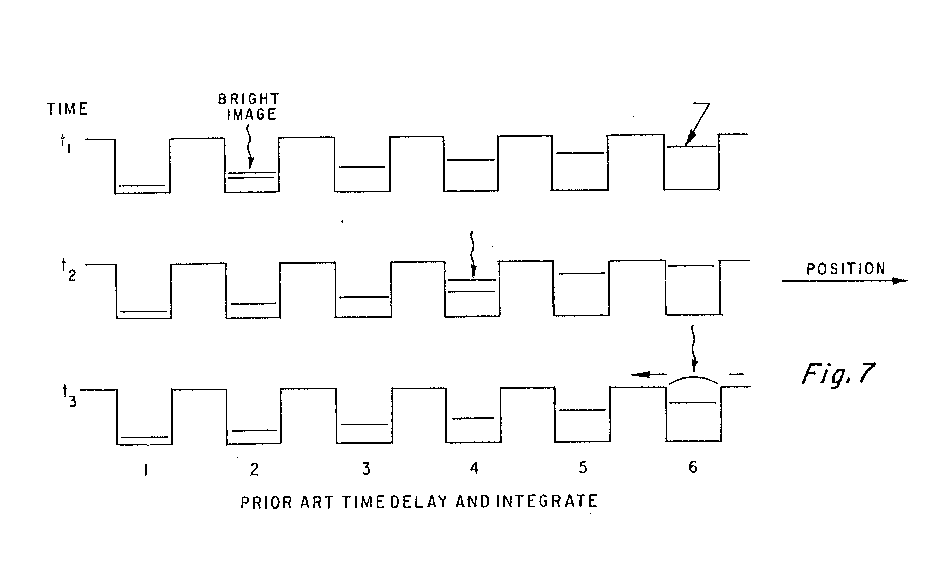

Figure 7 shows the potential wells of the prior art system utilizing the same integration period. As shown, the potential well at time $t_3$ is of insufficient depth to hold the charge packet and it overflows or avalanches. In the prior art, the maximum charge capacity is set by the maximum voltage and empty well depth at stage 1; this maximum is set in turn by electric field breakdown in the infrared sensing semiconductor. In the ramped array of Figure 6, the maximum voltage in the nearly-empty stage 1 well is low to prevent electric field breakdown while the last stage well is deep enough to contain the total charge. Electric field breakdown in well 6 of Figure 6 is prevented by the background generated in the last well.

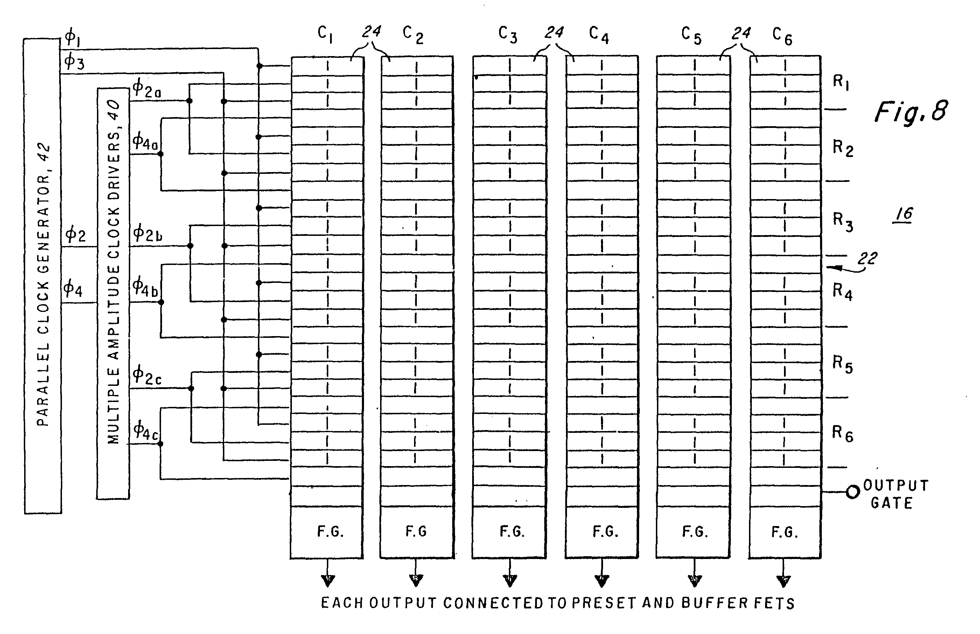

The serial shift register (Fig. 2a) can be replaced by a plurality of floating gates; one per column (Fig. 8). In this embodiment, each floating gate is provided with its own preset and buffer FETs. Each structure is that shown in Figure 2b which is that of Figure 4. The embodiment of Figure 8 has at least two advantages: (1) the complexity of the serial shift register and clocks is not required and (2) the frequency bandwidth which must be provided for the signal processing circuitry is much lower than that required for signal processing of output from the Figure 2a array. Smaller electronic bandwidth means less wide bandwidth noise at the buffer FET.

Although several embodiments of this invention have been described herein it will be apparent to a person skilled in the art that various modifications to the details of construction shown and described may be made without departing from the scope of this invention

## Claims

1. An infrared energy detector system comprising:

a scanning assembly 11 for scanning at a preselected rate a scene emitting infrared energy;

an infrared detector matrix (22) of charge coupled devices in the scanning path of the scanning assembly (11) for converting the impinging infrared energy into electrical charge packets representative of received infrared energy, said infrared detector matrix (22) comprising a plurality of charge coupled device elements (24) arranged in rows and columns, elements of the columns of charge coupled devices being selectively connected together to form a plurality of integration stages, and means (42) for applying selected phase clock pulses to said integration stages to synchronize the movement of the charge packets through said matrix with the scanning of the image of the scene by the scanning assembly (11); and

signal processing means (18) for processing the integrated signal into video signals representative of the infrared energy emanating from the scene, characterized in that the means (42) for applying phase clock pulses include means (40) for providing at least two phase clock pulses having the same phase but different amplitude to produce electrical charge packets in the first stage which are integrated with the charge packets of each succeeding stage of the plurality of integration stages to provide time delay with integration of charge packets within said matrix (22) thereby producing integrated signals representative of the scene.

2. An infrared energy detector system according to claim 1 further characterized in that the means (40) produces at least two phase clock pulses having first and second preselected stepped values of which the first is smaller in amplitude for the first stages and the second is larger in amplitude for the last stages.

3. An infrared energy detector system according to claim 1 characterized in that said means (40) is a variable amplitude generator.

4. An infrared energy detector system according to claim 1 characterized in that each stage of the matrix has four electrodes (30, 34, 36, 38) for four phase operation and a clock generator (42) and clock drivers (40) with separate connections to selected phase 2 and selected phase 4 electrodes, one connection to all phase 1 electrodes (36), and another connection to all phase 3 electrodes (38) to provide a quasi-two phase operation.

## Revendications

1. Système détecteur d'énergie infrarouge, comportant: un ensemble analyseur (11) destiné à analyser à une fréquence prédéterminée une scène émettant de l'énergie infrarouge; une matrice de détecteurs d'infrarouges (22) à dispositifs à couplage de charges dans le trajet d'analyse de l'ensemble analyseur (11) pour convertir l'énergie infrarouge incidente en de paquets de charges électriques représentants l'énergie infrarouge reçue, ladite matrice de détecteurs d'infrarouges (22) consistant en plusieurs éléments de dispositifs à couplage de charge (24) disposés en rangées et en colonnes, les éléments des colonnes des dispositifs à couplage de charges étant connectés sélectivement ensemble pour former plusieurs étages d'intégration, et un dispositif (42) appliquant des impulsions d'horloge de phase sélectionnée auxdits étages d'intégration pour synchroniser le mouvement des paquets de charges dans ladite matrice avec l'analyse de l'image de la scène par l'ensemble analyseur (11) et un dispositif de traitement de signaux (18) qui traite le signal intégré en des signaux vidéo représentant l'énergie infrarouge provenant de la scène, caractérisé en ce que le dispositif (42) qui applique des impulsions d'horloge de phases comporte un dispositif (40) pour produire au moins deux impulsions d'horloge de phase ayant la même phase mais des amplitudes différentes pour produire des paquets de charges électriques dans le premier étage qui sont intégrés avec les paquets de charges de chaque étage suivant des plusieurs étages d'intégration pour introduire un retard avec une intégration des paquets de charges dans ladite matrice (22), produisant ainsi des signaux intégrés représentant la scène.

2. Système détecteur d'énergie infrarouge selon la revendication 1, caractérisé en outre, en ce que le dispositif (40) produit au moins deux impulsions d'horloge de phase ayant une première et une seconde valeurs étagées prédéterminées dont la première a une amplitude plus faible pour les premiers étages et dont la seconde a une plus grande amplitude pour les derniers étages.

3. Système détecteur d'énergie infrarouge selon la revendication 1, caractérisé en ce que ledit dispositif (40) est un générateur d'amplitude variable.

4. Système détecteur d'énergie infrarouge selon la revendication 1, caractérisé en ce que chaque étage de la matrice comporte quatre électrodes (30, 34, 36, 38) pour un fonctionnement à quatre phases et un générateur d'horloge (42) et des circuits d'attaque d'horloge (40) avec des connexions séparées aux électrodes sélectionnées de phase 2 et aux électrodes sélectionnées de phase 4, une connexion avec toutes les électrodes de phase 1 (36) et une autre connexion avec toutes les électrodes de phase 3 (38) pour obtenir un fonctionnement quasibiphasé.

**Patentansprüche**

1. Detektorsystem für Infrarotenergie mit einer Abtastanordnung (11) zum Abtasten einer Infrarotenergie ausstrahlenden Szene mit einer vorgewählten Geschwindigkeit, einer Infrarotdetektormatrix (22) aus ladungsgekoppelten Bauelementen im Abtastweg der Abtastanordnung (11) zum Umsetzen der auftreffenden Infrarotenergie in elektrische Ladungspakete, die die empfangene Infrarotenergie repräsentieren, wobei die Infrarotdetektormatrix (22) mehrere ladungsgekoppelte Bauelemente (24) aufweist, und wobei Elemente der Spalten aus ladungsgekoppelten Bauelementen in ausgewählter Weise zur Bildung mehrerer Integrationsstufen miteinander verbunden sind, und ferner Mittel (42) aufweist, mit deren Hilfe an die Integrationsstufen ausgewählte Phasentaktimpulse angelegt werden, damit die Bewegung der Ladungspakete durch die Matrix mit dem Abtasten des Bildes der Szene durch die Abtastanordnung (11) synchronisiert wird, und Signalverarbeitungsmitteln (18) zum Verarbeiten der integrierten Signale in Videosignale, die die von der Szene ausgehende Infrarotenergie repräsentieren, dadurch gekennzeichnet, daß die Mittel (42) zum Anlegen der Phasentaktimpulse Mittel (40) enthalten, die wenigstens zwei Phasentaktimpulse mit der gleichen Phase, jedoch mit unterschiedlichen Amplituden abgeben, damit elektrische Ladungspakete in der ersten Stufe erzeugt werden, die mit den Ladungspaketen jeder nachfolgenden Stufe der mehreren Integrationsstufen integriert werden, so daß sich eine Zeitverzögerung mit der Integration der Ladungspakete innerhalb der Matrix (22) ergibt, wodurch integrierte Signale erzeugt werden, die die Szene repräsentieren.

2. Detektorsystem für Infrarotenergie nach Anspruch 1, dadurch gekennzeichnet, daß die Mittel (40) wenigstens zwei Phasentaktimpulse erzeugen, die erste und zweite vorgewählte abgestufte Werte aufweisen, von denen der erste eine kleinere Amplitude für die ersten Stufen und der zweite eine größere Amplitude für die letzten Stufen aufweist.

3. Detektorsystem für Infrarotenergie nach Anspruch 1, dadurch gekennzeichnet, daß die Mittel (40) von einem Generator mit variabler Amplitude bebildet sind.

4. Detektorsystem für Infrarotenergie nach Anspruch 1, dadurch gekennzeichnet, daß jede Stufe der Matrix vier Elektroden (30, 34, 36, 38) für einen Vierphasenbetrieb, einen Taktgenerator (42) und Takttreiber (40) enthält, wobei eigenen Verbindungen zu den Elektroden der ausgewählten Phase 2 und der ausgewählten Phase 4, eine Verbindung zu allen Elektroden (36) der Phase 1 und eine weitere Verbindung zu allen Elektroden (38) der Phase 3 vorgesehen sind, damit ein Quasi-Zweiphasenbetrieb entsteht.

LENS
ASSEMBLY

SCANNING
ASSEMBLY

DETECTOR
ASSEMBLY

VIDEO
ELECTRONICS
CIRCUITRY

LIGHT
SOURCE

*Fig. 1*

*Fig. 2b*

REFERENCE (—)

RESET PULSE (—)

INJECTION PULSE (+)

$V_{SS}(-)$

CDS

OUTPUT

SAMPLE (+)

CLAMP (+)

$V_{DD}(+)$

1

Fig.2a

0 066 020

Fig. 3

STAGE I    STAGE 6

$\phi_1$ $\phi_2$ $\phi_3$ $\phi_4$    $\phi_1$ $\phi_2$ $\phi_3$ $\phi_4$

36  30  38  32    36  30  38  32

34  28  26

Π-TYPE HgCdTe

SUBSTRATE BIAS = $V_S$

Fig. 4

Fig. 5

Fig. 6

BRIGHT IMAGE

TIME

$t_1$

$t_2$

$t_3$

1  2  3  4  5  6

RAMPED TIME DELAY, WITH INTEGRATION

→ DIRECTION OF MECHANICAL SCAN

→ DIRECTION OF SYNCHRONIZED SCAN

POSITION →

TIME

BRIGHT IMAGE

$t_1$

$t_2$

$t_3$

1  2  3  4  5  6

POSITION

0 066 020

Fig. 7

PRIOR ART TIME DELAY AND INTEGRATE

Fig. 8

EACH OUTPUT CONNECTED TO PRESET AND BUFFER FETS